# EUROPEAN PATENT SPECIFICATION

(11) **EP 2 276 128 B1**
(45) Date of publication and mention of the grant of the patent: **03.10.2012**
(21) Application number: 09007872.6
(22) Date of filing: 16.06.2009
(51) Int. Cl.: H02B 1/56, H02B 1/30, H05K 5/02, H05K 5/04

(54) **Double wall with internal reinforcements allowing the flow of air between the plates**
Doppelwand mit Innenverstärkungen mit Luftzirkulation zwischen den Platten
Paroi double avec renforts internes permettant le débit d'air entre les plaques

(43) Date of publication of application: 19.01.2011
(73) Proprietor: Nilko Metalurgia, Ltda., Pinhais/Curitiba/Parana (BR)
(72) Inventor: Huscher, Fraimundo, CEP:83325-360 Pinhais/Curitiba/Paraná (BR)
(74) Representative: Lorente Berges, Ana

(56) References cited:
- EP-A- 0 944 297
- WO-A-2009/071226
- DE-A1- 1 947 399

## Description

The present invention refers to a double wall for telecommunication closets in general, more specifically a double wall with internal reinforcements allowing the flow of air between the plates which, according to its general characteristics, has the basic principle of forming double walls for various applications, more specifically for use in sidewalls and doors of telecommunication closets in general, thus providing for better strength, durability and thermal dissipation between the internal and external sides of the closets. Double walls according to the invention include a system of spacers, formed by various bands of folded or waved plates, located in parallel and glued lengthwise between two plates, thus resulting in equal resistance in all spots of the plates. It is therefore possible to make less thick plates not losing their strength, thus offering material saving. Besides the items as mentioned above and the reduction in the final weight, this system allows air to circulate between the two plates, leaving their temperatures at ideal levels.

By analyzing double walls of the state of the art, we found three models as follows: simple double wall, double wall with central reinforcement and double wall with beehive-shaped reinforcements. The simple double wall is formed by two thick plates, which are fitted in, riveted or screwed to the structural profiles, making the center become vulnerable and fragile. The double wall with central reinforcement is functional considering its strength, but it is still limited to the use of thick plates, making its application become very expensive and heavy. Double walls with beehive-shaped reinforcements fill in the whole space between the plates, but do not allow the flow of air, being thus limited just regarding strength, and therefore are discarded for use in telecommunication closets including air circulators or heat exchangers.

Double walls are known from prior art documents EP-A-0 944 297, DE 1947 399 A1 or e.g. WO 2009/071226 A.

There are telecommunication closets made of double walls for thermal isolation, and others use these walls, jointly with air circulators or heat exchangers for air circulation and plate cooling, with no air flowing to inside the closet. The object of said cooling is to keep an ideal internal temperature for equipment placed inside it, also avoiding superheating or external and internal freezing of closets installed in countries with too high and/or too low temperatures.

In the current processes of making double walls as applied in the state of the art, the following techniques are usually employed: welding, rivets or screws. Welding does not allow appropriate locking of parts, since the access to the internal parts of the wall is very thin, being thus limited only lo welding near its ends, providing for low strength and difficult application. Rivets and screws are similarly applied and both require holes to be made on the plates, to rivet or screw internal reinforcements, leaving a final appearance with edges or heads outside the plate.

The present invention at issue is characterized by joining together components and processes in a different conception, which will meet various requirements of the nature of its use, i. e. double walls allowing air circulation between them with characteristics of higher strength, better thermal dissipation, lighter weight and lower costs.

The present invention consists in an up-to-date, efficient, safe and functional double wall with internal reinforcements allowing the flow of air between the plates, formed by a set of correctly included solutions in the area of strength and temperature control composing a full and different double wall. With characteristics of its own, incorporating a unique and specific structure with high durability and strength, made of aluminum or similar with equal or better beauty and strength, containing, fully integrated and symmetrically located between them, two plates which sizes vary according to the area to be closed. The plates are located in parallel, by keeping a given distance between them; this distance is determined by a set of bands, formed by folded or waved plates, located and perpendicularly glued between the plates and parallel to each other. The hands act as spacers and as a plate resistance and reinforcement element and, since they are parallel to each other, they form air flow channels, thus allowing plates to be cooled off, by always keeping the internal temperature under ideal conditions, so to enable the formation of one single, full and safe double wall, which forms and internal and external dispositions allow a perfect placement for a wide range of applications, especially for the composition of structures and doors for telecommunication closets in general, with the specific object to generate better safety, strength, lightness and huge savings by reducing plate thickness.

All the double wall components at issue are fixed with glue (epoxy), thus providing for excellent finishing and an easy, simple and economic manufacturing process.

Folded or waved plate bands keep a preferential distance of 25.0 mm between them and this distance forbids the direct flow of air from one end to the other, forcing it to circulate through the whole route of the plate forms, so that the air occupies all spaces and provides for constant and uniform temperature throughout them.

Folded or waved plate bands also work as an internal protection grid, to protect the equipment against undesirable access when installed in public ways or similar. Therefore, double walls with internal reinforcements allowing the flow of air between the plates is intended to improve and guarantee the safety of equipments protected by them, especially against vandalism, theft and non-authorized access, added to improve and guarantee the strength of the set, by incorporating last generation technological solutions to provide for an excellent safety level, strength, durability and quality to the whole process of hold and use in its applications and preferably in the application for closets containing telecommunication equipment. £.

Objects, advantages and further important characteristics of the invention at issue may be more easily understood when read jointly with the attached figures, wherein:
Figure 1 shows a perspective view and a cut of the double wall with internal reinforcements allowing the flow of air between the plates.

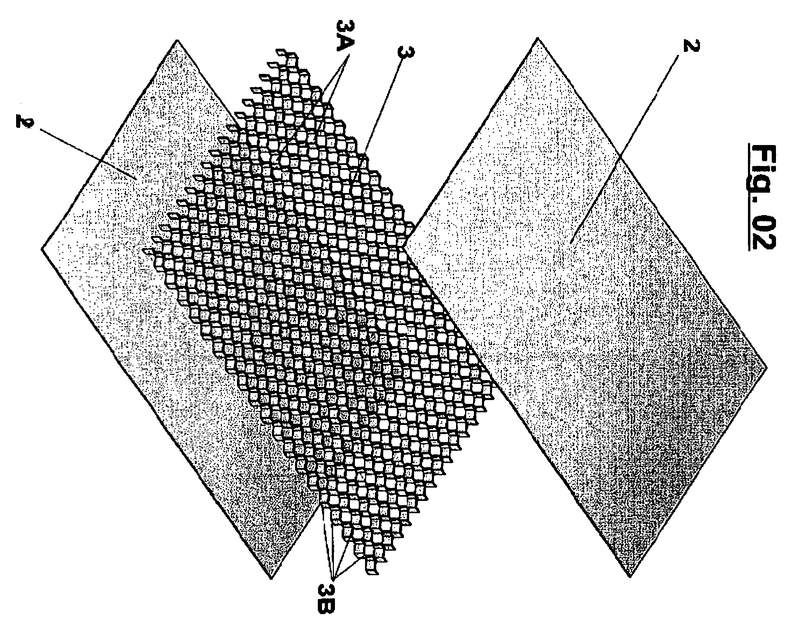

Figure 2 shows an exploded view of the double wall with internal reinforcements allowing the flow of air between the plates.

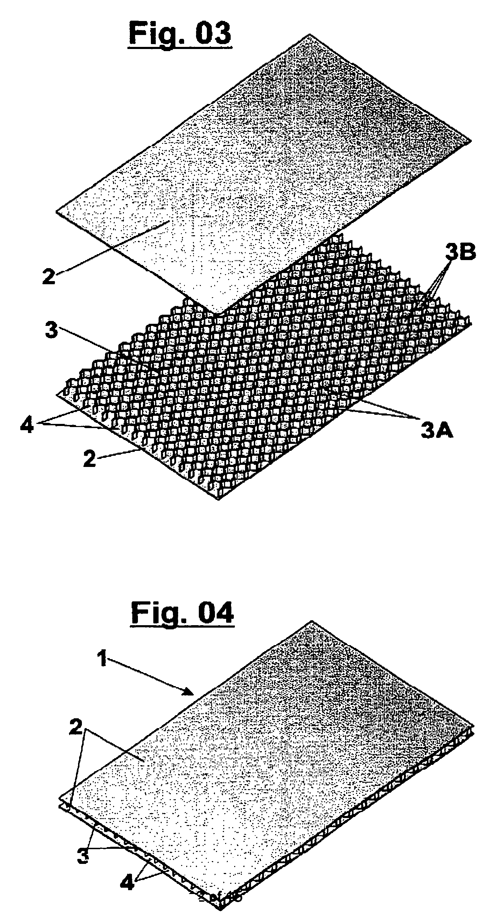

Figure 3 shows an exploded view of the double wall with internal reinforcements allowing the flow of air between the plates in the arrangement with bands glued over one of the plates.
Figure 4 shows a perspective view of the double wall with internal reinforcements allowing the flow of air between the plates.

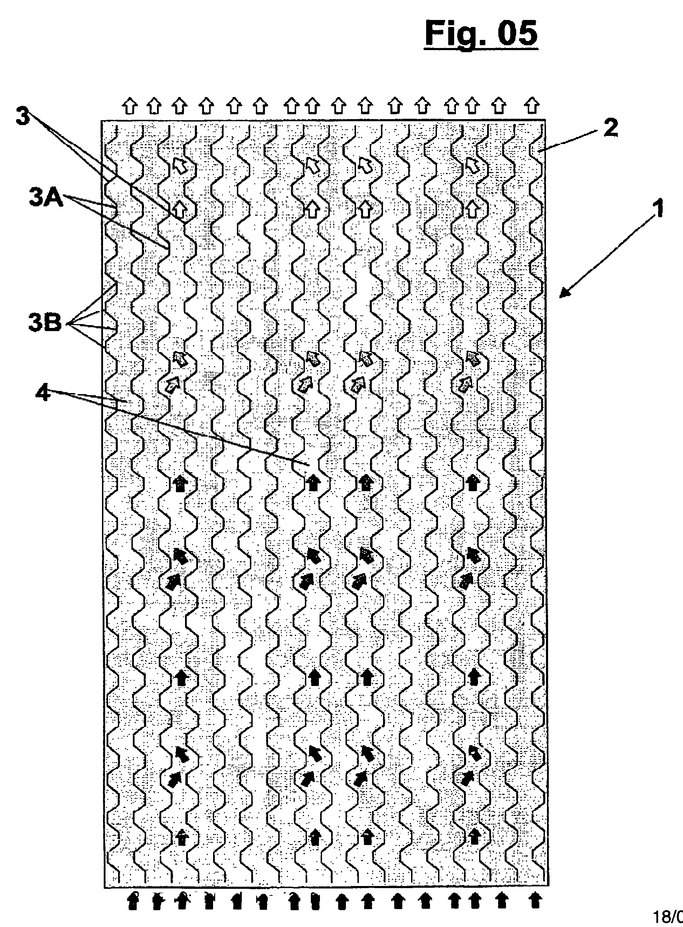

Figure 5 shows a cut view of the showing the path of air inside the double wall with internal reinforcements allowing the flow of air between the plates.

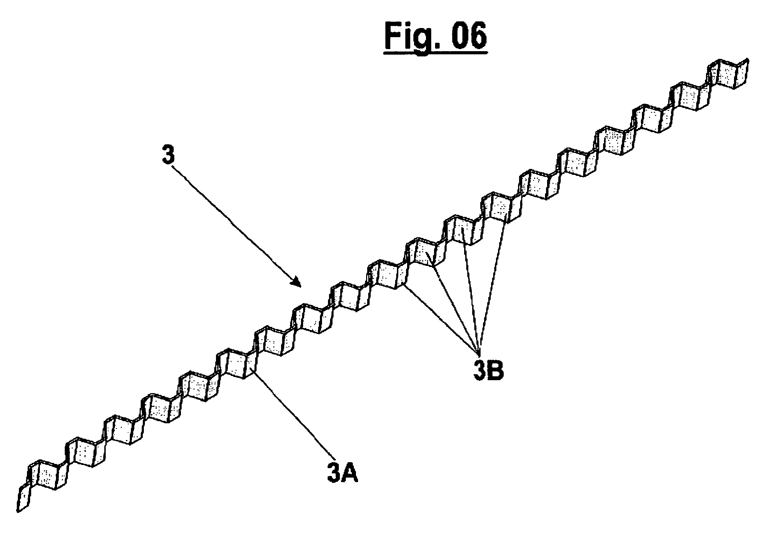

Figure 6 shows a perspective view of one of the folded bands of the double wall with internal reinforcements allowing the flow of air between the plates.
Figure 7 shows a perspective view of one of the waved bands of the double wall with internal reinforcements allowing the flow of air between the plates.

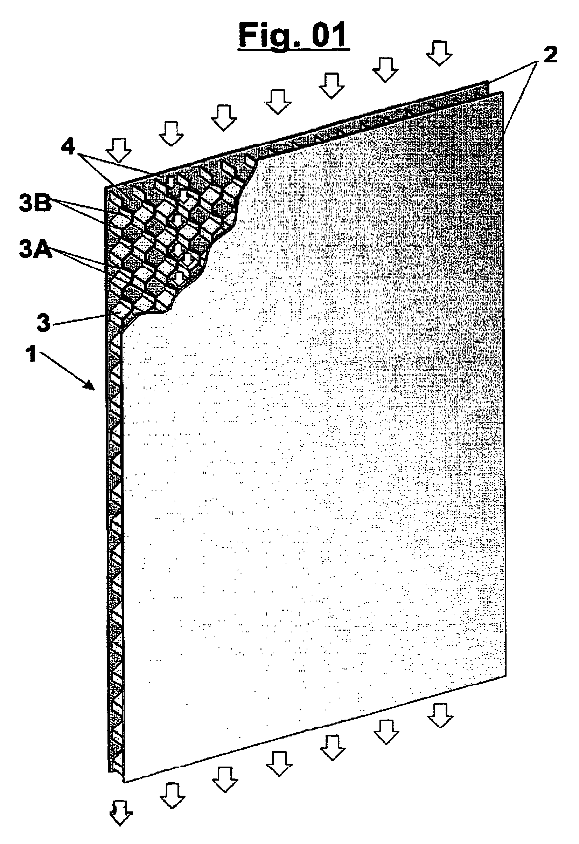

As inferred from the attached figures showing and integrating the present description of the patent of invention for a "DOUBLE WALL WITH INTERNAL REINFORCEMENTS ALLOWING THE FLOW OF AIR BETWEEN THE PLATES", Figure 1 generally shows it as developed for various applications, more specifically for a composition of doors and structures for telecommunication closets in general, with the object to promote a better control of the internal temperature, structural strength and cost reduction by reducing plate thickness; being comprised by a full and unique double wall (1) with characteristics of its own, incorporating a unique and specific composed monoblock structure which is highly durable and strong, with a general rectangular shape, but which may vary according to its application, containing two perfectly integrated and symmetrically located plates (2) with general rectangular shapes, made of aluminum or similar, positioned in parallel, and keeping a certain distance from each other; said distance is given by a set of bands (3) composed by folded plates (3A) which contain various ridges with straight sections (3B), being the bands (3) located crosswise between the plates (2) and parallel to each other, at a preferential distance of 25.0 mm among themselves, acting as spacers and as a reinforcement and strength element for plates (2) and, for being in parallel, they form air flow paths (4), thus allowing the plates (2) to be cooled and always keeping the internal temperature under ideal conditions.

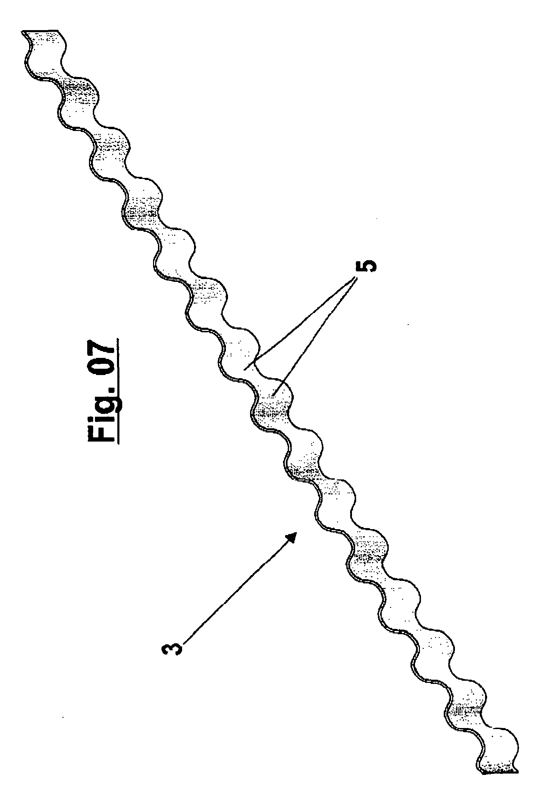

Figure 7 shows it comprised by a band (3), composed by waved plates (5) and keeping the other characteristics.

By including this system, it is possible to reduce plate (2) thickness, substituting them with thinner plates (2), which are lighter and more economical.

The double wall (1) with internal reinforcements allowing the flow of air through the plates (2), by having its components fully glued to each other, does not get loose, does not break, bend or tear, reaching a high performance and efficiency rate, added to high durability and full security. After being fully glued, i. e. perfectly integrated to each other, components are locked and tied so to avoid them from getting loose by their own while in use, by making the set fully available for application to telecommunication closets in general. Therefore, the double wall (1) may be easily and directly used, mainly concerning the durability and safety of its components.

For all the above, this is a product to be well received by companies or customers purchasing the products composed by the double walls (1) of the present invention, since they present numerous advantages, such as: great security, trustfulness and agility in application, since the walls are light and easy to be installed; high yielding and performance in its application due to its general conception; better security, high durability and strength, added to low or non-existent wearing of the set as a whole; reduced costs, offering a very good cost-benefit ratio; high range of reach; high versatility and flexibility in applications; perfect and direct adaptation to a wide range of telecommunication closets in general and the certainty to offer a product fully meeting basic rules and conditions as required to its application, such as security, strength and thermal exchange.

All these attributes allow us to classify the double wall (1) with internal reinforcements allowing the flow of air between the plates (2) as a fully versatile, efficient, practical and safe way for a wide range of applications, preferably to close structures and doors of closets holding telecommunication equipment in general, no matter its eventual general characteristics, also being very easily applied and handled, added to the high performance and excellent general characteristics. However, measurements, sizes and quantities may vary as a direct consequence of the general requirements of each application.

## Claims

1. DOUBLE WALL WITH INTERNAL REINFORCEMENTS ALLOWING AIR TWO PASS BETWEEN THE PLATES for use in various applications, more specifically for the composition of doors and structures of telecommunication closets in general, with the object to better control the internal temperature, structural resistance and reduce costs for reducing plate thickiness; being the double wall (1) **characterized by** a monobloc structure of general rectangular shape containing an internal reparation system, formed by a set of bands (3) made of folded (3A) or waved (5) plates made of aluminum or similar material, which are located in parallel at a preferable distance of 25.0 mm between them, and glued lengthwise and perpendicularly between two rectangular, symmetrically located plates (2) made at aluminium or similar, positioned in parallel, and keeping a certain distance from each one; said distance given by the set of bounds (3) air flow channels (4) are formed by the bands (3) located in parallel, avoiding the direct passage of air between one end and the other, with the object to keep a constant and uniform temperature throughout the plates (2).

2. "DOUBLE WALL WITH INFERNAL REINFORCEMENTS ALLOWING AIR TO PASS BETWEEN THE PLATES", of claim 1, **characterized by** molded plates (3A) containing various ridges with straight sections (3B).

## Patentansprüche

1. DOPPELWAND MIT INTERNEN VERSTÄRKUNGEN, DIE EINEN LUFTSTROM ZWISCHEN DEN PLATTEN ERMÖGLICHEN, zur Verwendung in verschiedenen Anwendungen, insbesondere für die Herstellung von Türen und Strukturen von Telekommunikationsgehäusen im Allgemeinen, mit dem Zweck, die Innentemperatur besser zu beherrschen, strukturelle Widerstandsfähigkeit und Kostenreduktion bei reduzierter Plattendicke; wobei die Doppelwand (1) **gekennzeichnet ist durch** eine Monoblock-Struktur allgemein rechteckiger Form, die ein internes Trennsystem besitzt, das aus einem Satz von Bändern (3) gebildet wird, die aus gefalteten (3A) oder gewellten (5) Platten aus Aluminium oder ähnlichern Material bestehen, die parallel angeordnet sind, in einem bevorzugtem Abstand von 25,0 mm voneinander, und die längs und senkrecht zwischen zwei rechteckige, symmetrisch angeordnete Platten (2) geklebt sind, bestehend aus Aluminium oder ähnlichem Material, parallel angeordnet, und unter Einhaltung eines gewissen Abstands voneinander, wobei der besagte Abstand **durch** den Satz Bänder (3) vorgegeben ist, **durch** die parallel angeordnete Bänder (3) werden Luftstramkonäle (4) gebildet, wobei der direkte Luftdurchtritt von einem Ende zum anderen vermieden wird, mit dem Zweck, eine konstante und einheitliche Temperatur zwischen den Platten (2) aufrecht zu erhalten.

2. "DOPPELWAND MIT INTERNEN VERSTÄRKUNGEN, DIE EINEN LUFTDURCHTRITT ZWISCHEN DEN PLATTEN ERMÖGLICHEN" nach Anspruch 1, **gekennzeichnet durch** gefaltete Platten (3A) mit unterschiedlichen Kanten und geraden Abschnitten (3B).

## Revendications

1. DOUBLE PAROI AVEC RENFORTS INTERNES PERMETTANT LA CIRCULATION D'AIR ENTRE LES PLANQUES, utilisable dans toute une diversité d'applications, mais plus particulièrement dans la composition de portes et structures d'armoires de télécommunication en général, dans le but de mieux réguler la température interne et la résistance structurelle ainsi que de réduire les coûts grâce à la diminution d'épaisseur de la plaque; ladite double paroi étant (1) **caractérisée par** une structure monobloc de forme globale rectangulaire contenant un système de séparation interne constitué d'un ensemble de bandes (3) de feuille d'aluminium ou matériau similaire pliées (3A) ou ondulées (5), paralléles entre elles, espacées de préférence de 25,0 mm, collées dans leur longueur et perpendiculairement entre deux plaques rectangulaires (2) symétriquement positionnées, en aluminium ou matériau similaire, parallèles et conservant une certaine distances entre elles, la dite distance étant donnée par l'ensemble de bandes (3), des canaux de circulation d'air (4) parallèles entre eux sont formés par les bandes (3), interdisant la circulation directe d'air d'une extrémité à l'autre, afin de maintenir une température constante et uniforme sur l'ensemble des plaques (2).

2. «DOUBLE PAROI AVEC RENFORTS INTERNES PERMETTANT LA CIRCULATION D'AIR ENTRE LES PLAQUES » selon la revendication 1 **caractérisée par** des feuilles pliées (3A) contenant divers stries et avec des tronçons droits (3B).
